# EUROPEAN PATENT APPLICATION

(11) **EP 4 704 146 A1**
(43) Date of publication of application: **04.03.2026**
(21) Application number: 24796564.3
(22) Date of filing: 04.03.2024
(51) Int. Cl.: H01L 23/02, H01L 23/08, H01L 23/34, H01L 23/50, H01L 27/146

(54) **SEMICONDUCTOR PACKAGE, SEMICONDUCTOR DEVICE, AND METHOD FOR MANUFACTURING SEMICONDUCTOR PACKAGE**

(30) Priority: 28.04.2023 JP 2023074381
(71) Applicant: Sony Semiconductor Solutions Corporation, Atsugi-shi, Kanagawa 243-0014 (JP)
(72) Inventor: OOTAKI, Yutaka, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/007951
(87) International publication number: WO 2024/224806

(57) **Abstract**

The present technology suppresses performance deterioration caused by heat in a semiconductor package provided with two semiconductor chips. A semiconductor package includes a first semiconductor chip, a first lead frame, a second semiconductor chip, and a second lead frame. The first semiconductor chip is mounted on a first island of the first lead frame. A second island of the second lead frame is disposed at a predetermined spacing from the first island, and the second semiconductor chip is mounted on the second island.

## Description

### Technical Field

The present technology relates to a semiconductor package. Specifically, the present technology relates to a semiconductor package including a lead frame, a semiconductor device, and a method for manufacturing a semiconductor package.

### Background Art

Semiconductor packages have been used to protect a semiconductor chip and provide an external terminal when the semiconductor chip is mounted on a substrate. For example, a semiconductor package having a structure in which a chip of a solid-state imaging element is mounted on a front surface of an island in a lead frame and a chip of a peripheral circuit is mounted on a back surface of the island has been proposed (refer to PTL 1, for example).

### Citation List

### Patent Literature

PTL1: JP H6-85222 A

### Summary

### Technical Problem

In the related art described above, two semiconductor chips are mounted in one semiconductor package, thereby reducing a mounting area as compared with a case in which one semiconductor chip is mounted in each of two semiconductor packages. However, in the related art described above, the two semiconductor chips are mounted on both sides of one lead frame, resulting in a possibility that heat generated by one semiconductor chip may conduct to the other semiconductor chip, causing failure or characteristic variations. In addition, the semiconductor chips may warp by heat generated during operation of the semiconductor chips. Such failures, characteristic variations, and warping cause a problem of a reduction in the performance of the device.

The present technology has been made in view of such circumstances, and an object thereof is to suppress performance deterioration caused by heat in a semiconductor package provided with two semiconductor chips.

### Solution to Problem

The present technology has been made to solve the problems described above, and a first aspect thereof is a semiconductor package and a control method thereof. The semiconductor package includes a first semiconductor chip, a first lead frame including a first island on which the first semiconductor chip is mounted, a second semiconductor chip, and a second lead frame including a second island on which the second semiconductor chip is mounted, the second island being disposed at a predetermined spacing from the first island. According to this configuration, an effect of suppressing performance deterioration caused by heat is achieved.

Further, in this first aspect, the first semiconductor chip may be mounted on a front surface of the first island, the second semiconductor chip may be mounted on a front surface of the second island, and a back surface of the first island relative to the front surface and a back surface of the second island relative to the front surface may be disposed with the predetermined spacing between the back surfaces. According to this configuration, an effect of suppressing conduction of heat between the chips is achieved.

Further, in this first aspect, the first lead frame may include a plurality of first inner leads and the first island, the second lead frame may include a plurality of second inner leads and the second island, and a specific first inner lead of the plurality of first inner leads and a specific second inner lead of the plurality of second inner leads may be connected. According to this configuration, an effect in that the inner leads are connected to each other in the semiconductor package is achieved.

Further, in this first aspect, the specific first inner lead and the specific second inner lead may be connected to a power supply potential or a ground potential. According to this configuration, an effect in that the two semiconductor chips are commonly connected to the power supply potential or the ground potential is achieved.

Further, in this first aspect, the specific first inner lead and the specific second inner lead may transmit a signal from one of the first semiconductor chip and the second semiconductor chip to the other. According to this configuration, an effect of facilitating signal transmission between the chips in the semiconductor package is achieved.

Further, in this first aspect, the semiconductor package may further include a mold resin, and one of the first island and the second island may be embedded in the mold resin. According to this configuration, an effect of suppressing warping of the semiconductor chip is achieved.

Further, in this first aspect, the semiconductor package may further include a frame-like member including a cavity, and a heat-conductive resin that dissipates heat, generated in one of the first semiconductor chip and the second semiconductor chip, to the frame-like member, and the first island and the second island may be disposed in the cavity. According to this configuration, an effect of improving heat dissipation performance is achieved.

Further, in this first aspect, one of the first semiconductor chip and the second semiconductor chip may be a sensor chip configured to generate image data by photoelectric conversion, and the other of the first semiconductor chip and the second semiconductor chip may be a logic chip configured to process the image data. According to this configuration, an effect of imaging image data is achieved.

Further, a second aspect of the present technology is a semiconductor device including a semiconductor package including a first semiconductor chip. a first lead frame including a first island on which the first semiconductor chip is mounted, a second semiconductor chip, and a second lead frame including a second island on which the second semiconductor chip is mounted, the second island being disposed at a predetermined spacing from the first island; and a mounting substrate on which the semiconductor package is mounted. According to this configuration, an effect of suppressing performance deterioration of the device caused by heat is achieved.

Further, in this second aspect, the semiconductor device may further include a heat sink connected to the first lead frame and the second lead frame. According to this configuration, an effect of improving the heat dissipation performance is achieved.

### Brief Description of Drawings

[Fig. 1]

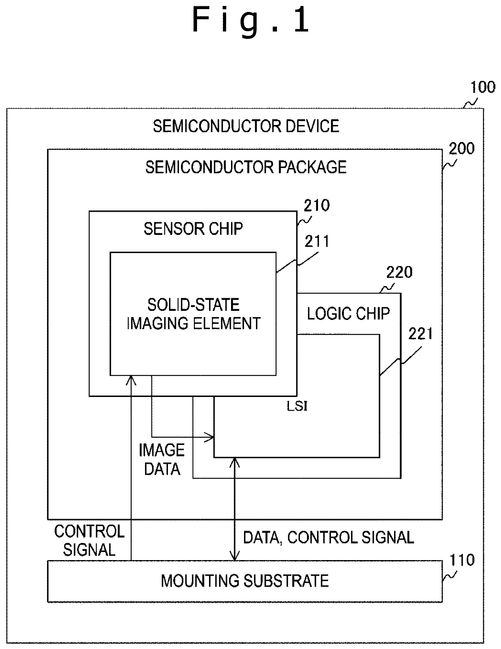

   Fig. 1 is a block diagram depicting a configuration example of a semiconductor device according to a first embodiment of the present technology.
[Fig. 2]

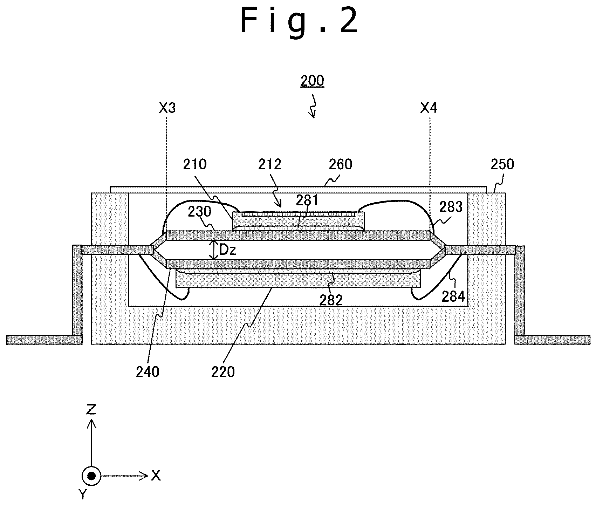

   Fig. 2 is a cross-sectional view depicting a configuration example of a semiconductor package according to the first embodiment of the present technology.
[Fig. 3]

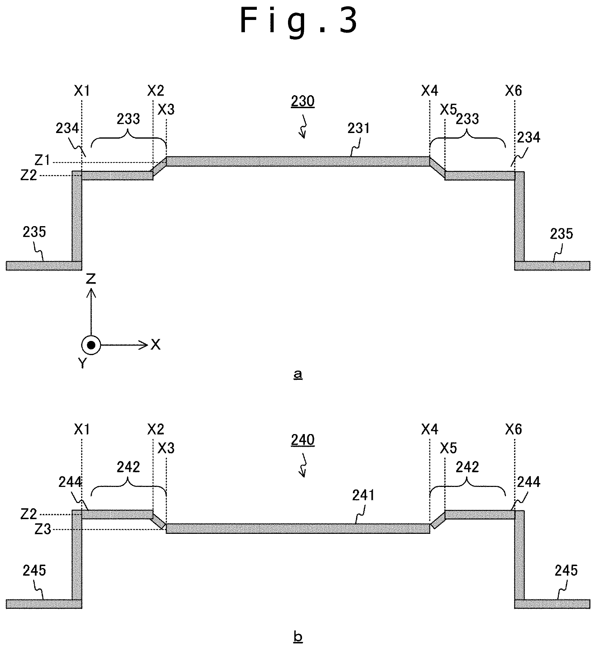

   Fig. 3 is an example of cross-sectional views of lead frames according to the first embodiment of the present technology.
[Fig. 4]

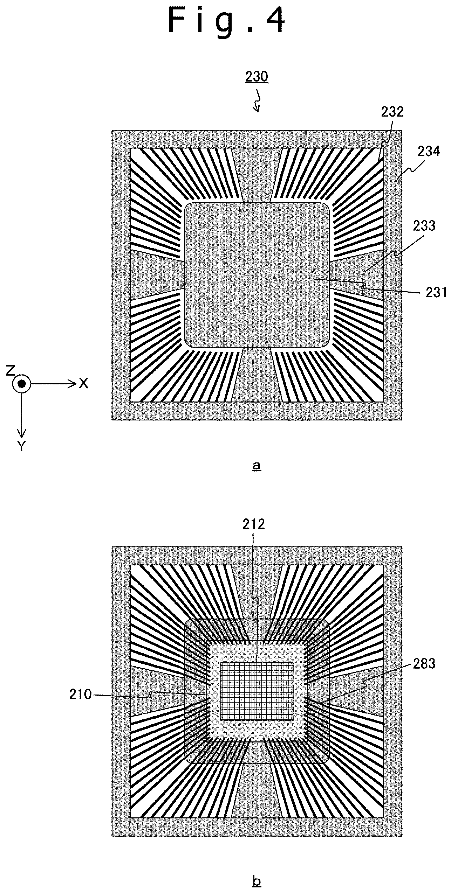

   Fig. 4 is an example of top views of the lead frame on an upper side according to the first embodiment of the present technology.
[Fig. 5]

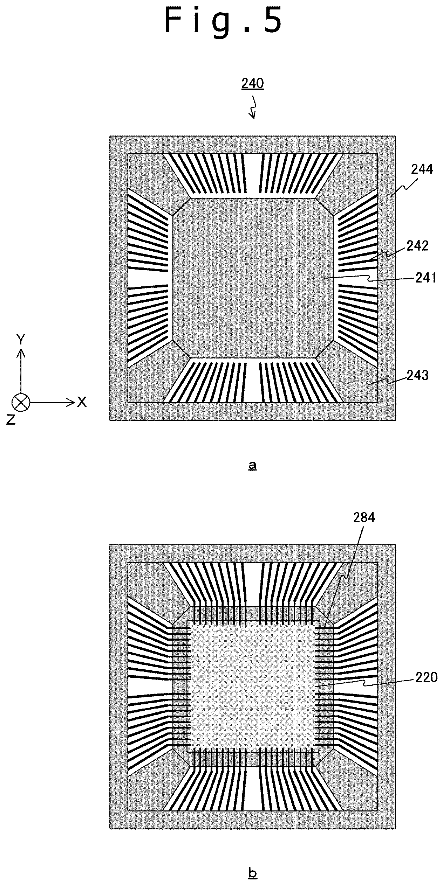

   Fig. 5 is an example of bottom views of the lead frame on a lower side according to the first embodiment of the present technology.
[Fig. 6]

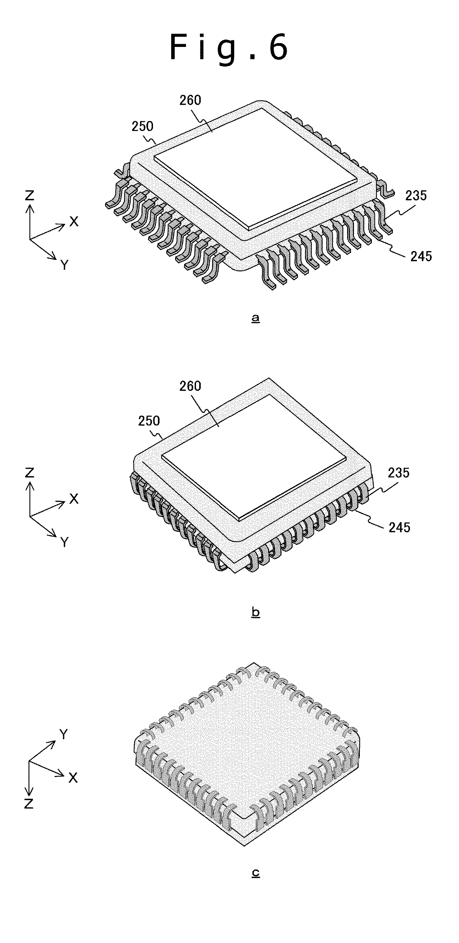

   Fig. 6 is an example of external views of the semiconductor package according to the first embodiment of the present technology.
[Fig. 7]

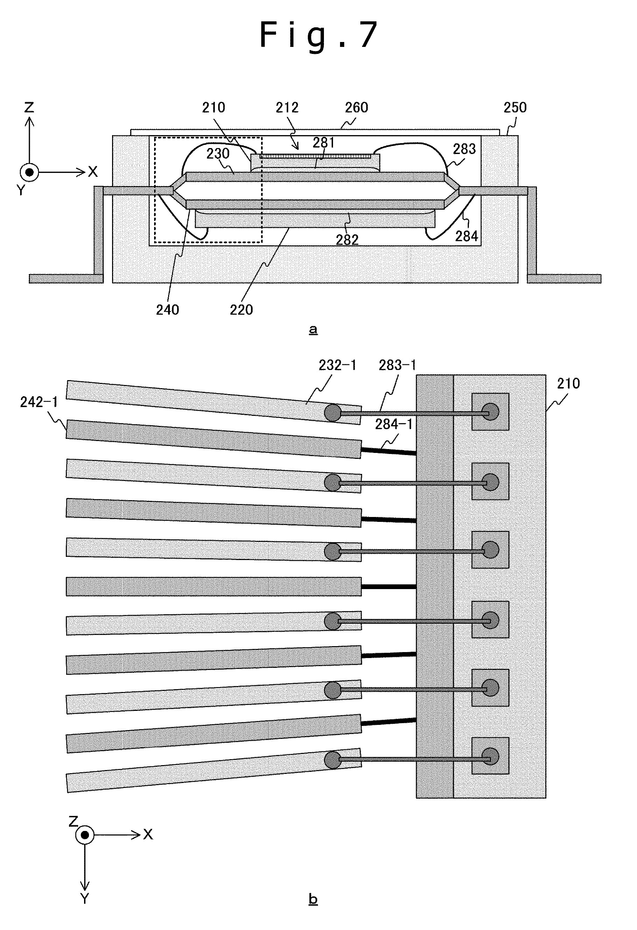

   Fig. 7 is an example of a cross-sectional view and a plan view of the semiconductor package according to the first embodiment of the present technology.
[Fig. 8]

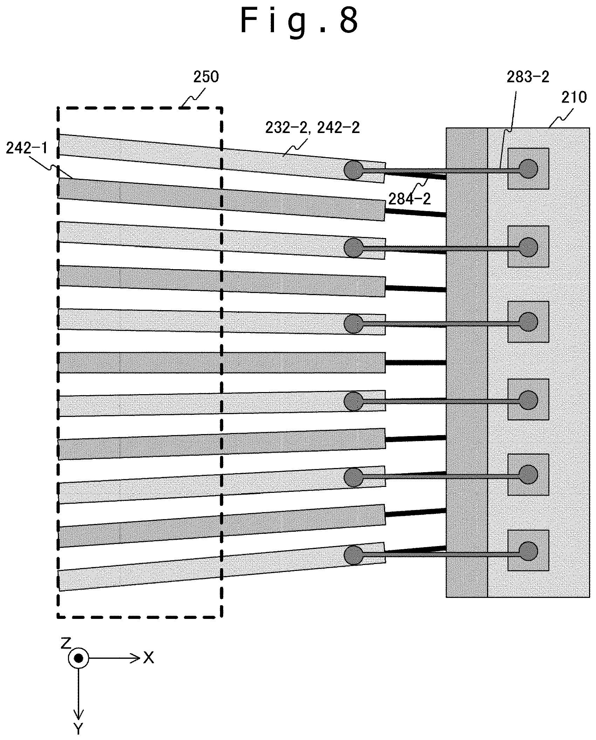

   Fig. 8 is an example of a plan view of locations where inner leads are arrayed according to the first embodiment of the present technology.
[Fig. 9]

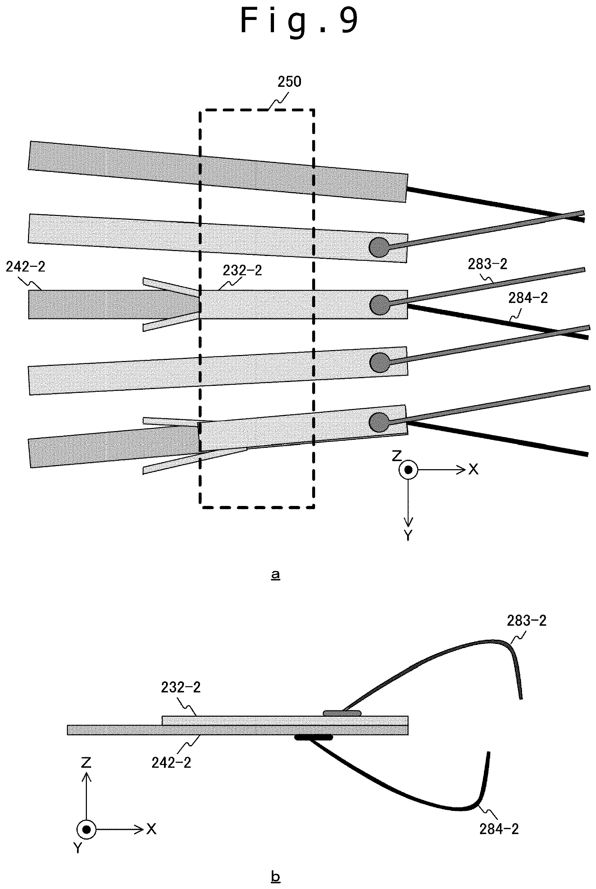

   Fig. 9 is an example of a top view and a cross-sectional view of the vicinity of a resin frame according to the first embodiment of the present technology.
[Fig. 10]

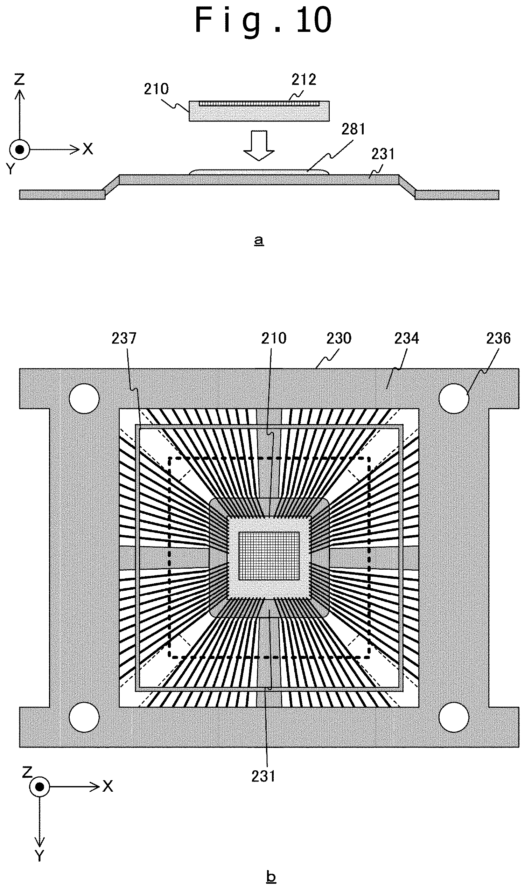

   Fig. 10 is a diagram for describing a process of mounting a sensor chip according to the first embodiment of the present technology.
[Fig. 11]

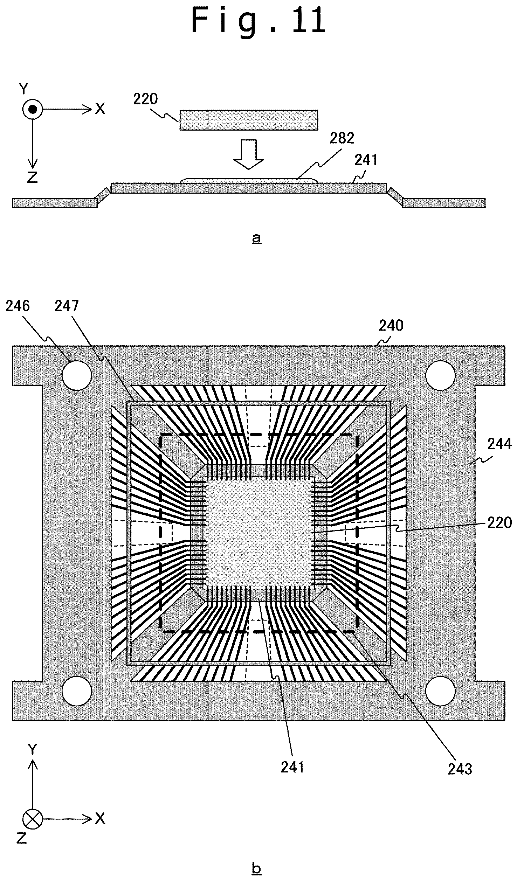

   Fig. 11 is a diagram for describing a process of mounting a logic chip according to the first embodiment of the present technology.
[Fig. 12]

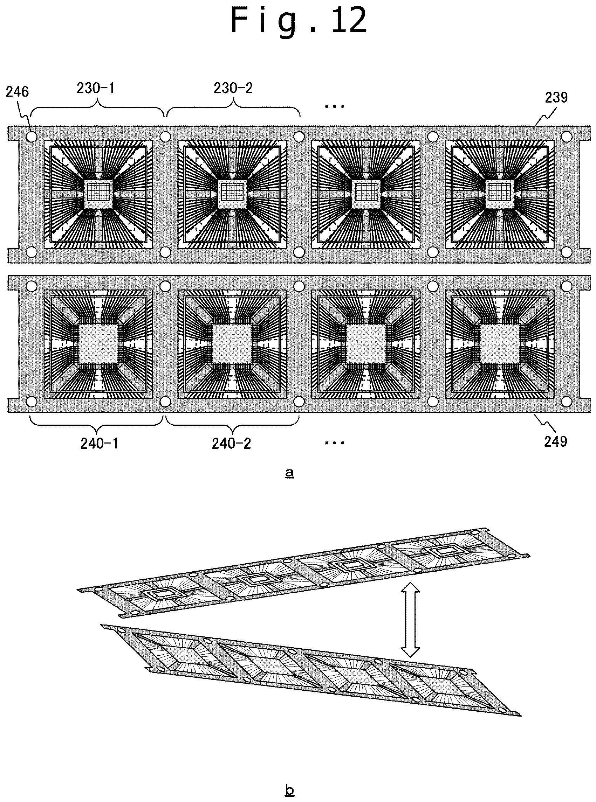

   Fig. 12 is a diagram for describing a process of superimposing collective frames according to the first embodiment of the present technology.
[Fig. 13]

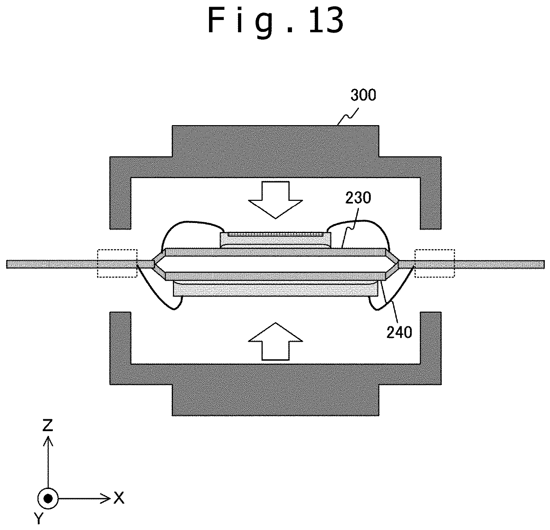

   Fig. 13 is a cross-sectional view illustrating an example of the lead frames overlapped according to the first embodiment of the present technology.
[Fig. 14]

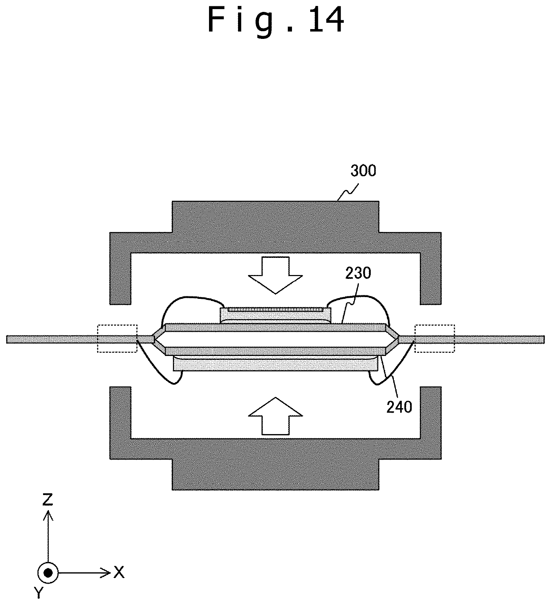

   Fig. 14 is a diagram for describing a process of fitting the inner leads according to the first embodiment of the present technology.
[Fig. 15]

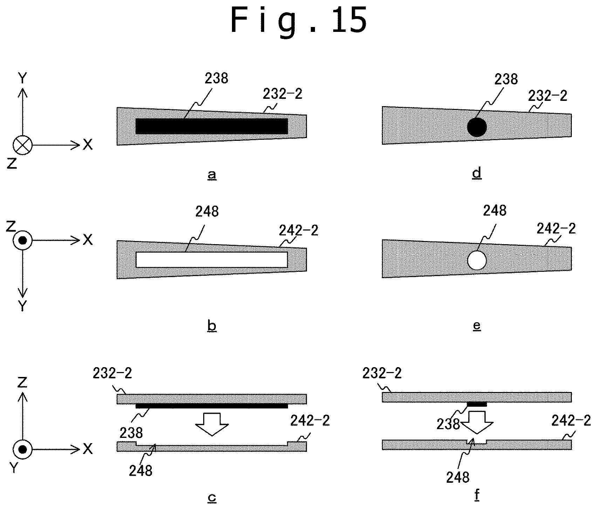

   Fig. 15 is an example of plan views and cross-sectional views of a fitting portion of the inner lead according to the first embodiment of the present technology.
[Fig. 16]

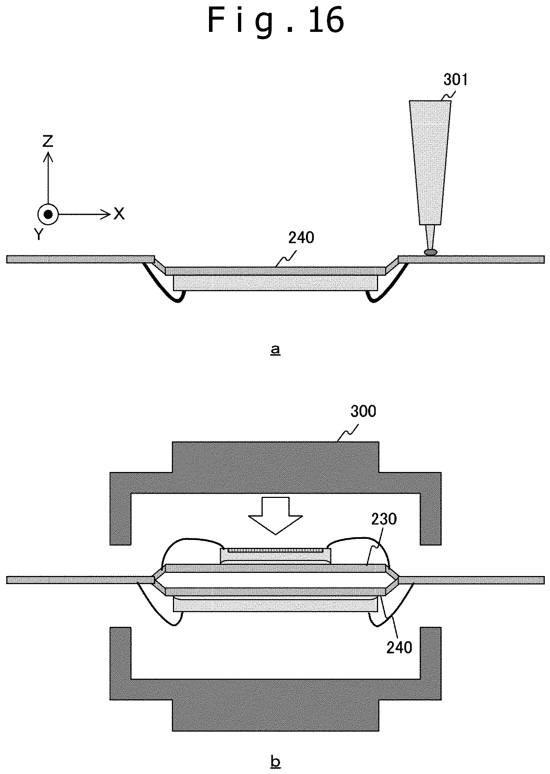

   Fig. 16 is a diagram for describing a process of bonding the inner lead according to the first embodiment of the present technology.
[Fig. 17]

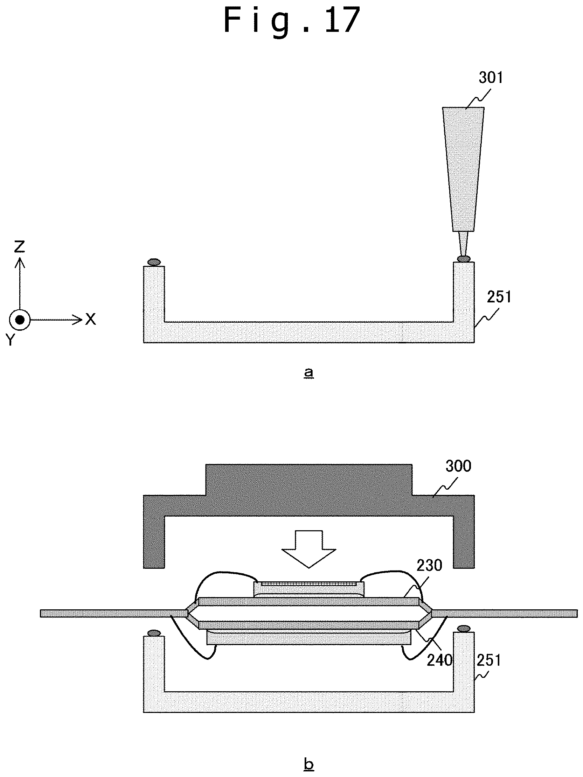

   Fig. 17 is a diagram for describing a process of mounting the lead frame on a lower resin frame according to the first embodiment of the present technology.
[Fig. 18]

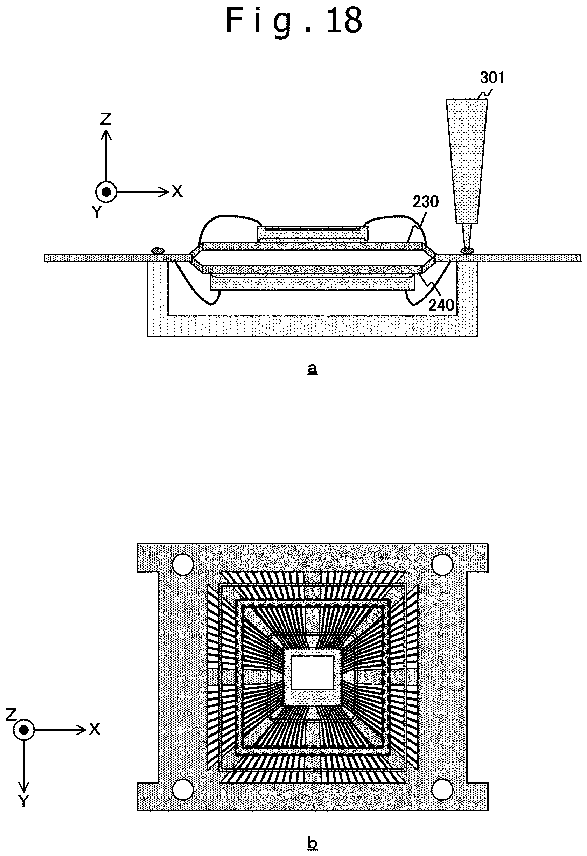

   Fig. 18 is a diagram for describing a process of applying an adhesive to the lead frame according to the first embodiment of the present technology.
[Fig. 19]

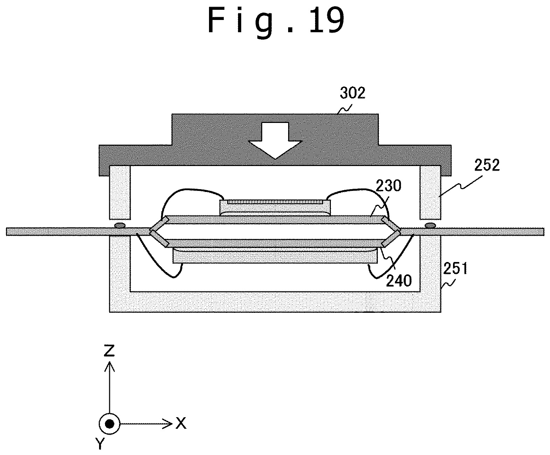

   Fig. 19 is a diagram for describing a process of bonding an upper resin frame according to the first embodiment of the present technology.
[Fig. 20]

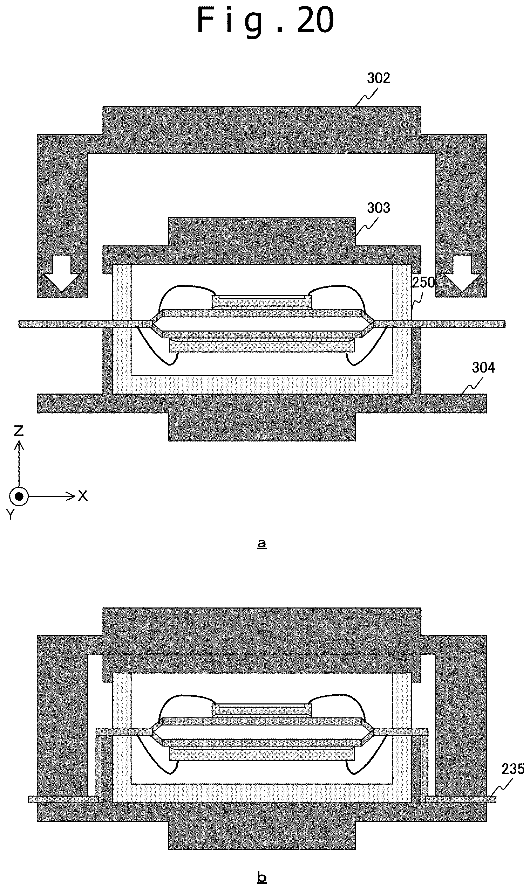

   Fig. 20 is a diagram for describing a process of forming an outer lead according to the first embodiment of the present technology.
[Fig. 21]

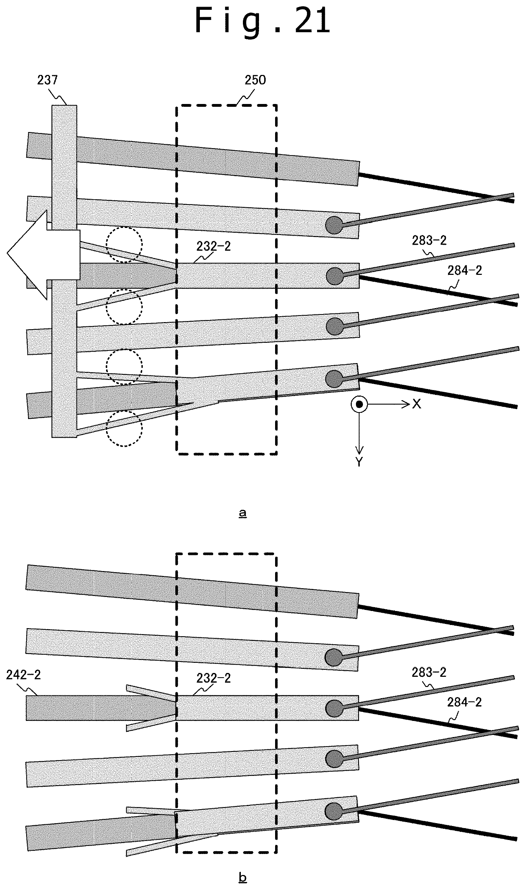

   Fig. 21 is an example of plan views of an arrayed portion of the inner leads before and after removal of unnecessary portions according to the first embodiment of the present technology.
[Fig. 22]

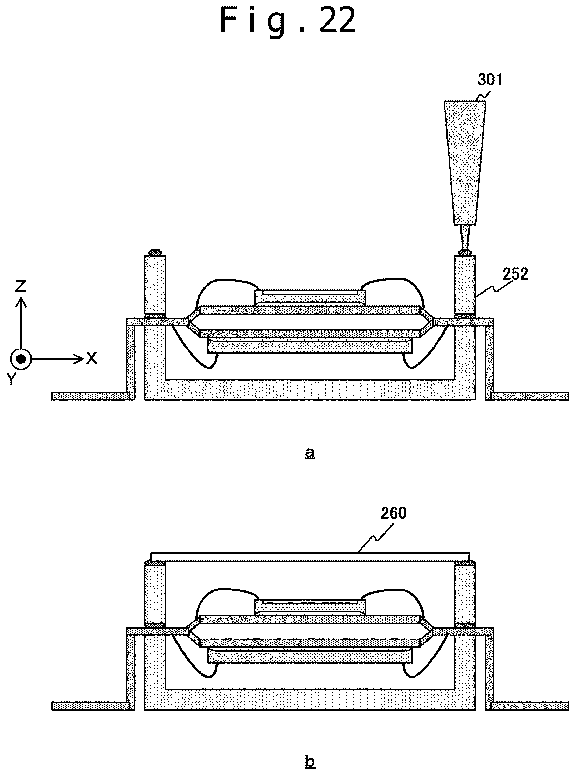

   Fig. 22 is a diagram for describing a process of mounting a dustproof glass according to the first embodiment of the present technology.
[Fig. 23]

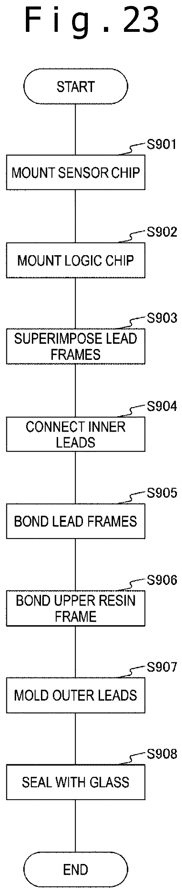

   Fig. 23 is a flowchart illustrating an example of a method for manufacturing the semiconductor package according to the first embodiment of the present technology.
[Fig. 24]

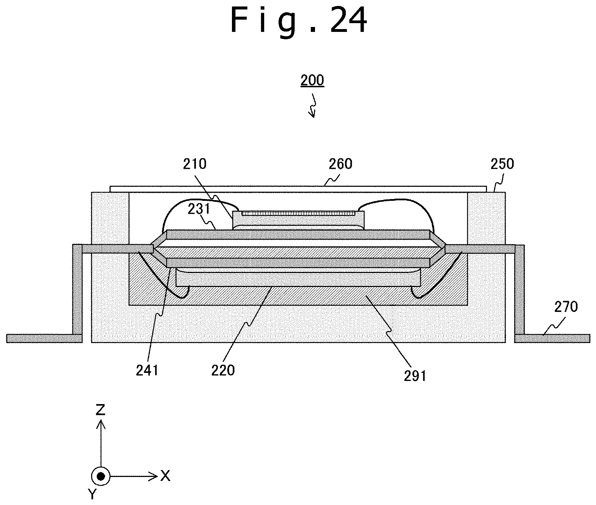

   Fig. 24 is a cross-sectional view depicting a configuration example of the semiconductor package according to a second embodiment of the present technology.
[Fig. 25]

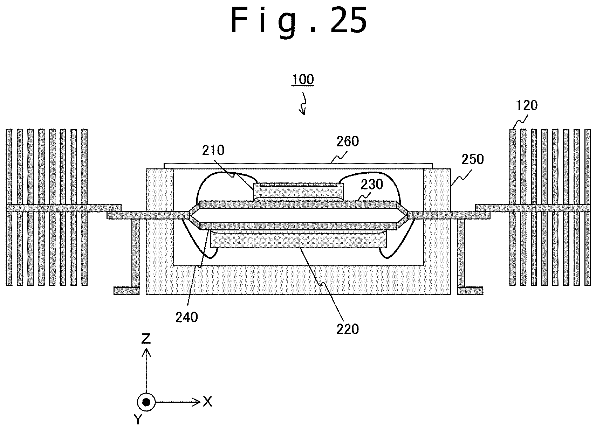

   Fig. 25 is a cross-sectional view depicting a configuration example of the semiconductor device according to a third embodiment of the present technology.
[Fig. 26]

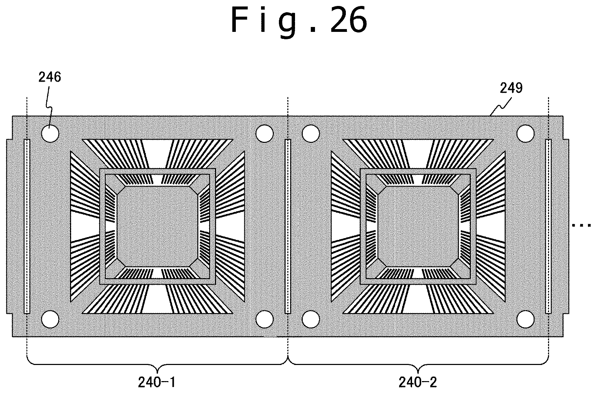

   Fig. 26 is an example of a plan view of the collective frame on the lower side according to the third embodiment of the present technology.
[Fig. 27]

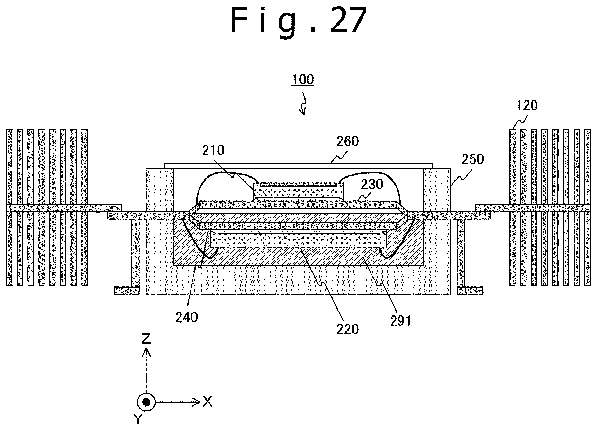

   Fig. 27 is a cross-sectional view of a case in which the second embodiment is applied to the third embodiment of the present technology.
[Fig. 28]

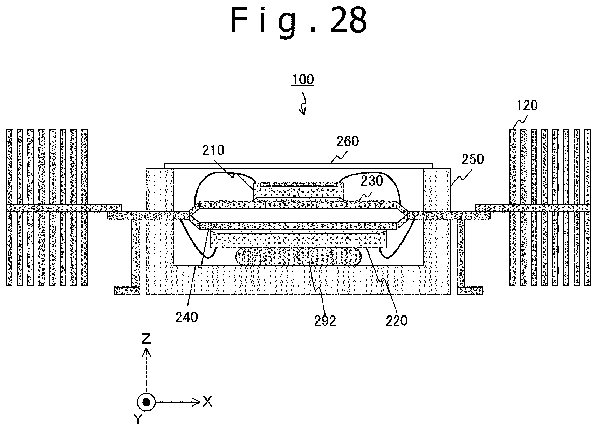

   Fig. 28 is a cross-sectional view depicting a configuration example of the semiconductor device according to a modification of the third embodiment of the present technology.
[Fig. 29]

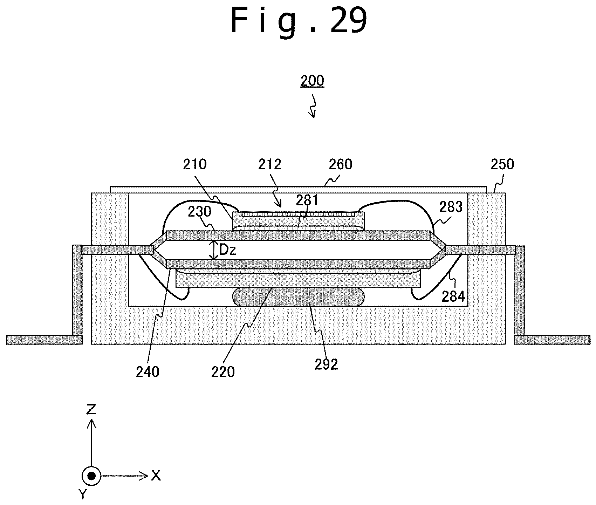

   Fig. 29 is a cross-sectional view of a case in which a heat-conductive resin in the modification of the third embodiment is added to the first embodiment of the present technology.
[Fig. 30]

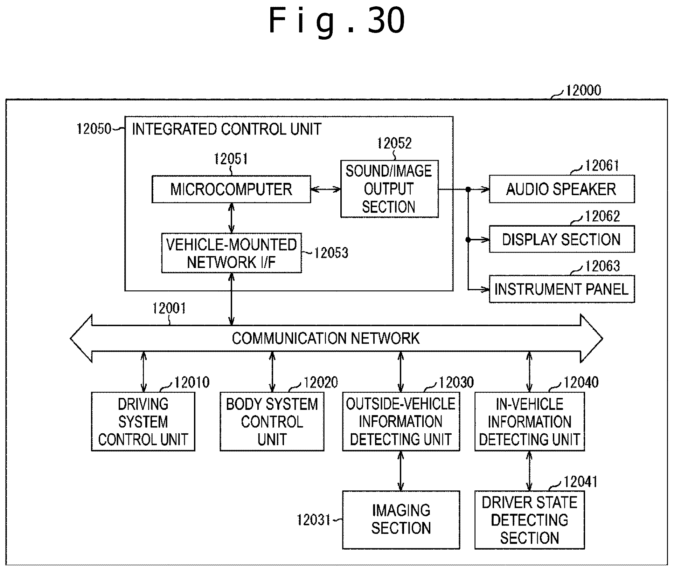

   Fig. 30 is a block diagram depicting a schematic configuration example of a vehicle control system.
[Fig. 31]

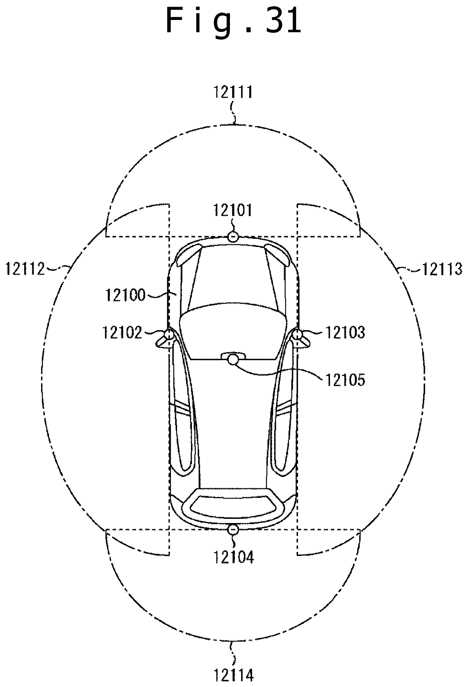

   Fig. 31 is an explanatory view depicting an example of an installation position of an imaging section.

### Description of Embodiments

Hereinafter, modes for carrying out the present technology (hereinafter, referred to as embodiments) will be described. Description will be made in the following order.
1. First Embodiment (example in which a predetermined spacing is provided between upper and lower islands)
2. Second Embodiment (example in which an island on a lower side is embedded in a mold resin with a predetermined spacing between the upper and lower islands)
3. Third Embodiment (example in which a heat sink is connected between the upper and lower islands with a predetermined spacing therebetween)
4. Application Example of Mobile Body

### 1. First Embodiment

### Configuration Example of Semiconductor Device

Fig. 1 is a block diagram depicting a configuration example of a semiconductor device 100 according to an embodiment of the present technology. The semiconductor device 100 includes a semiconductor package 200 and a mounting substrate 110 on which the semiconductor package 200 is mounted. Examples of the semiconductor device 100 include a smartphone, a personal computer, and a digital camera having an imaging function.

A sensor chip 210 and a logic chip 220 are disposed in the semiconductor package 200. The sensor chip 210 is provided with a solid-state imaging element 211 that generates image data by photoelectric conversion. This solid-state imaging element 211 transmits the image data to the logic chip 220.

The logic chip 220 is provided with a large scale integration (LSI) 221 that processes the image data from the sensor chip 210. This LSI 221 processes the image data and transmits the processed data to the mounting substrate 110.

Further, from the mounting substrate 110, various control signals are transmitted to the sensor chip 210 and the logic chip 220.

### Configuration Example of Semiconductor Package

Fig. 2 is a cross-sectional view depicting a configuration example of the semiconductor package 200 according to the first embodiment of the present technology. This semiconductor package 200 includes the sensor chip 210, the logic chip 220, a lead frame 230, a lead frame 240, a resin frame 250, and a dustproof glass 260.

Hereinafter, a predetermined axis parallel to a front surface of the dustproof glass 260 is defined as an "X axis", and an axis perpendicular to the front surface is defined as a "Z axis". An axis perpendicular to the X axis and the Z axis is defined as a "Y axis". Further, a direction from the lead frame 240 to the lead frame 230 is defined as an "upward" direction. The drawing is a cross-sectional view as viewed from a Y-axis direction.

The lead frame 230 on an upper side includes an island, an inner lead, a frame, and an outer lead. In the drawing, the island of the lead frame 230 is disposed within a range from a coordinate X3 to a coordinate X4. The sensor chip 210 is mounted on an upper surface of this island on the upper side by a die bonding resin 281 and a wire 283 (gold wire or the like). A pixel array section 212 in which a plurality of pixels are arrayed is formed on an upper surface of this sensor chip 210. Note that the island may be referred to as a die pad.

Hereinafter, of both surfaces of the lead frame 230 on the upper side, a surface (that is, upper surface) on which the sensor chip 210 is mounted is referred to as a "front surface".

The lead frame 240 on a lower side includes an island, an inner lead, a frame, and an outer lead. In the drawing, the island of the lead frame 240 is disposed within a range from the coordinate X3 to the coordinate X4. The logic chip 220 is mounted on a lower surface of this island on the lower side by a die bonding resin 282 and a wire 284 (gold wire or the like) . Hereinafter, of both surfaces of the lead frame 240 on the lower side, a surface (that is, lower surface) on which the logic chip 220 is mounted is referred to as a "front surface".

Further, a back surface (lower surface) of the island of the lead frame 230 on the upper side and a back surface (upper surface) of the island of the lead frame 240 on the lower side are disposed with a predetermined spacing Dz therebetween.

Note that the sensor chip 210 is an example of a first semiconductor chip described in the claims, and the lead frame 230 is an example of a first lead frame described in the claims. The logic chip 220 is an example of a second semiconductor chip described in the claims, and the lead frame 240 is an example of a second lead frame described in the claims.

The resin frame 250 is a resin member including a cavity therein. For example, a space having a recessed shape as viewed from an X-axis direction or the Y-axis direction is formed as a cavity in the resin frame 250. The respective islands of the lead frames 230 and 240 are disposed in this cavity. Note that a frame made of ceramic may be used instead of the resin frame 250. Further, the resin frame 250 is an example of a frame-like member described in the claims.

The dustproof glass 260 seals an upper portion of the cavity.

Here, a configuration in which only one lead frame is disposed and the sensor chip 210 and the logic chip 220 are mounted on the upper surface and the lower surface of the island of the lead frame is assumed as a comparative example. In the recent logic chip 220 including the increased number of the pixels and compatible with high-speed transmission, a heat generation amount tends to increase due to the increase in the number of pixels and the increase in speed. In the comparative example, heat generated in the logic chip 220 may be conducted to the sensor chip 210 on a back side thereof, causing failure or characteristic fluctuation in the sensor chip 210. Further, due to the heat generated in the sensor chip 210 or the logic chip 220, the chip may warp. Further, thermal stress may occur in the resin frame 250 due to the heat generated in the chip, and the thermal stress may cause warping in the mounting substrate 110.

In contrast, in the drawing, the sensor chip 210 and the logic chip 220 are mounted on the islands of different lead frames, and a predetermined spacing is provided between the respective islands of the lead frames. Therefore, heat is less likely to be conducted from the logic chip 220 to the sensor chip 210 compared to a case in the comparative example. Accordingly, it is possible to suppress performance deterioration of the semiconductor device 100 caused by failure or characteristic fluctuation in the sensor chip 210 or warping of the mounting substrate 110. In addition, the island on the upper side is lifted and the island on the lower side is suspended, making the chip less likely to warp and making it possible to suppress performance deterioration of the semiconductor device 100 caused by such warping.

### Configuration Example of Lead Frame

Fig. 3 is an example of cross-sectional views of the lead frames 230 and 240 according to the first embodiment of the present technology. a in the drawing is a cross-sectional view of the lead frame 230 on the upper side, and b is a cross-sectional view of the lead frame 240 on the lower side.

As illustrated in a in the drawing, the lead frame 230 on the upper side includes an island 231, a plurality of inner leads such as an inner lead 233, a frame 234, and an outer lead 235. The frame 234 in the vicinity of a coordinate X1 and a coordinate X6 is a member having a frame-like shape that supports the island 231 via the inner leads 233. Further, the inner leads 233 are leads for lifting the island 231, and are bent upwardly at coordinates X2 and X5. The inner lead 233 on the left side is bent in a direction toward the upper right at the coordinate X2, and the inner lead 233 on the right side is bent in a direction toward the upper left at the coordinate X5. With the inner leads 233 being bent upwardly, given Z2 as a Z coordinate of the frame 234, the Z coordinate of the island 231 is Z1 thereabove. Further, in addition to the inner leads 233, inner leads (not illustrated) for electrical connection are provided in the lead frame 230.

As illustrated in b in the drawing, the lead frame 240 on the lower side includes an island 241, a plurality of inner leads such as an inner lead 242, a frame 244, and an outer lead 245. The frame 244 in the vicinity of the coordinate X1 and the coordinate X6 supports the island 241 via leads (not illustrated) for suspension other than the inner leads 242. Further, the inner leads 242 are leads for electrical connection and are bent downwardly at the coordinates X2 and X5. The inner lead 242 on the left side is bent in a direction toward the lower right at the coordinate X2, and the inner lead 242 on the right side is bent in a direction toward the lower left at the coordinate X5. Given Z2 as a Z coordinate of the frame 244, the Z coordinate of the island 241 is Z3 therebelow.

The lead frame 230 is superimposed on the lead frame 240 described above and disposed in the resin frame 250, thereby obtaining the structure illustrated in Fig. 2. With the island 231 on the upper side lifted upwardly and the island 241 on the lower side suspended downwardly, the islands 231 and 241 are supported by the frames 234 and 244 with a certain spacing therebetween.

Fig. 4 is an example of top views of the lead frame 230 on the upper side according to the first embodiment of the present technology. a in the drawing is an example of a top view of the lead frame 230 before the sensor chip 210 is mounted, and b in the drawing is an example of a top view of the lead frame 230 after the sensor chip 210 is mounted. In a and b in the drawing, the outer lead 235 is omitted.

As illustrated in a in the drawing, the island 231 is disposed at a center of a region surrounded by the frame 234 having a frame-like shape. Further, a plurality of inner leads extending inward are connected to the frame 234. These inner leads are divided into inner leads 232 for electrical connection and the inner leads 233 for lifting and supporting the island 231. The inner leads 233 connect, for example, the four sides of the frame 234 and the four sides of the island 231.

As illustrated in b in the drawing, the sensor chip 210 is die-bonded to the island 231 and electrically connected to the inner leads 232 by the wires 283.

Note that the inner lead 232 is an example of a first inner lead described in the claims.

Fig. 5 is an example of bottom views of the lead frame 240 on the lower side according to the first embodiment of the present technology. a in the drawing is an example of a bottom view of the lead frame 240 before the logic chip 220 is mounted, and b in the drawing is an example of a bottom view of the lead frame 240 after the logic chip 220 is mounted. In a and b in the drawing, the outer lead 245 is omitted.

As illustrated in a in the drawing, the island 241 is disposed at a center of a region surrounded by the frame 244 having a frame-like shape. Further, a plurality of inner leads extending inward are connected to the frame 244. These inner leads are divided into the inner leads 242 for electrical connection and inner leads 243 for suspending and supporting the island 241. The inner leads 243 connect, for example, the four corners of the frame 244 and the four corners of the island 241.

Note that the inner lead 242 is an example of a second inner lead described in the claims.

As illustrated in Fig. 4 and Fig. 5, the inner leads 233 and 243, for support, support locations differing from each other so as not to overlap. In a case in which the logic chip 220 is likely to generate heat, preferably the inner leads 233 and 243 do not overlap. Note that, in a case in which the logic chip 220 is less likely to generate heat, the inner leads 233 and 243 may support the same location.

Fig. 6 is an example of external views of the semiconductor package 200 according to the first embodiment of the present technology. As illustrated in a in the drawing, the outer leads 235 and 245 are L-shaped. Such a semiconductor package is called a quad flat package (QFP).

Note that, as illustrated in b in the drawing, the outer leads 235 and 245 can be formed in a J-shape. Such a semiconductor package is called a quad flat J-leaded package (QFJ) . c in the drawing depicts a perspective view of a lower surface side of the QFJ.

Fig. 7 is a diagram for describing an array of the inner leads according to the first embodiment of the present technology. a in the drawing is an example of a cross-sectional view of the semiconductor package 200. b in the drawing is an example of a top view of a location surrounded by a dotted line in a in the drawing.

As illustrated in b in the drawing, one end of an inner lead 232-1 on the upper side is connected to the sensor chip 210 on the upper side by a wire 283-1. One end of the inner lead 242-1 on the lower side is connected to the logic chip 220 (not illustrated) on the lower side by a wire 284-1. These inner leads 232-1 and 242-1 for electrical connection are arrayed so as not to come into contact with each other when the lead frames 230 and 240 are overlapped. Within the range illustrated in the drawing, the upper and lower inner leads do not overlap. However, in a case in which the upper and lower chips are used in common, the upper and lower inner leads can overlap.

For example, as illustrated in Fig. 8, an inner lead 232-2 on the upper side and an inner lead 242-2 on the lower side can be vertically overlapped and connected. This drawing is a top view, and the inner lead 242-2 on the lower side is hidden by the inner lead 232-2 on the upper side and cannot be seen. Further, in the drawing, for convenience of description, the resin frame 250 is omitted. The resin frame 250 is actually disposed in the portion surrounded by the dotted line.

One end of the inner lead 232-2 on the upper side is connected to the sensor chip 210 on the upper side by a wire 283-2. One end of the inner lead 242-2 on the lower side is connected to the logic chip 220 (not illustrated) on the lower side by a wire 284-2.

As illustrated in the drawing, the inner leads 232-2 and 242-2 that are overlapped are connected to a power supply potential or a ground potential that is common to the upper and lower chips, for example. Alternatively, these inner leads 232-2 and 242-2 are used to transmit signals (image data and the like) from the sensor chip 210 to the logic chip 220.

Note that the inner lead 232-2 is an example of a specific first inner lead described in the claims. The inner lead 242-2 is an example of a specific second inner lead described in the claims.

Fig. 9 is an example of a top view of the vicinity of the resin frame 250 according to the first embodiment of the present technology. a in the drawing depicts a top view of the vicinity of the resin frame 250. b in the drawing depicts a cross-sectional view of the location illustrated in a in the drawing.

As illustrated in a and b in the drawing, the inner leads 242-2 under the inner leads 232-2 are exposed outside the resin frame 250, for example.

### Method for Manufacturing Semiconductor Package

Next, a method for manufacturing the semiconductor package 200 will be described with reference to Fig. 10 to Fig. 22. First, as illustrated in a of Fig. 10, the sensor chip 210 is bonded to the island 231 of the lead frame 230 with the die bonding resin 281.

Next, as illustrated in b in the drawing, the sensor chip 210 is wire-bonded. At this time, the outer lead is not formed, and a predetermined number of positioning holes 236 for positioning are formed in the outer frame 234. Further, a support frame 237 for supporting a portion of the lead frame is disposed inside the frame 234. The thick dotted line in b in the drawing indicates a location where the lead frame is bent upwardly. The thin dotted line indicates a disposed location of the lead frame for suspension on the lower side.

Further, as illustrated in a of Fig. 11, the logic chip 220 is bonded to the island 241 of the lead frame 240 with the die bonding resin 282.

Next, as illustrated in b in the drawing, the logic chip 220 is wire-bonded. At this time, the outer lead is not formed, and a predetermined number of positioning holes 246 for positioning are formed in the outer frame 244. Further, a support frame 247 for supporting a portion of the lead frame is disposed inside the frame 244. The thick dotted line in b in the drawing indicates a location where the lead frame is bent upwardly. The thin dotted line indicates a disposed location of the lead frame for lifting on the upper side.

The die bonding and the wire bonding illustrated in Fig. 10 and Fig. 11 are performed on collective frames 239 and 249 illustrated in a of Fig. 12. The collective frame 239 includes a plurality of the lead frames 230, such as lead frames 230-1 and 230-2. The collective frame 249 includes a plurality of the lead frames 240, such as lead frames 240-1 and 240-2.

After the wire bonding, as illustrated in b in the drawing, respective back surfaces of the collective frames 239 and 249 are superimposed. At this time, respective positions of the collective frames 239 and 249 are aligned with each other by inserting pins or the like into the positioning holes.

Fig. 13 is a cross-sectional view of one of a plurality of sets of the lead frames 230 and 240 in the collective frames 239 and 249 in an overlapped state. Within a range from a coordinate X0 to the coordinate X3 and a range from the coordinate X4 to a coordinate X7, the upper and lower frames are layered and the upper and lower inner leads are arrayed. In addition, within a range from the coordinate X3 to the coordinate X4, the upper and lower islands are disposed with a predetermined spacing therebetween.

Then, as illustrated in Fig. 14, the upper and lower inner leads to be electrically connected are sandwiched from above and below by a mold 300 and fitted to each other.

a and b of Fig. 15 depict plan views of a fitting portion surrounded by the dotted line in Fig. 14. a in Fig. 15 is a plan view of the inner lead 232-2 on the upper side, and b in the drawing is a plan view of the inner lead 242-2 on the lower side. As illustrated in a in the drawing, a protrusion 238 having a rectangular shape is formed on the inner lead 232-2 on the upper side, and a recess 248 having a rectangular shape is formed on the inner lead 242-2 on the lower side. As illustrated in c in the drawing, the protrusion 238 on the upper side and the recess 248 on the lower side are fitted to each other.

Note that, in a and b in the drawing, the protrusion 238 and the recess 248 have rectangular shapes as viewed from a Z-axis direction, but the shapes thereof may be circular as illustrated in d, e, and f in the drawing.

Further, in Fig. 14 and Fig. 15, the upper and lower inner leads are electrically connected by the fitting of the recess and the protrusion, but the connection method is not limited thereto.

For example, as illustrated in a of Fig. 16, a conductive resin or a cream solder can be applied to a connection location of the lead frame 240 on the lower side by a dispenser 301, and the lead frame 230 on the upper side can be pressed by the mold 300 as illustrated in b in the drawing.

Then, as illustrated in a of Fig. 17, after connection of the upper and lower inner leads, an adhesive is applied to an upper portion of a lower resin frame 251 by the dispenser 301. This lower resin frame 251 corresponds to a portion on the lower side of the resin frame 250.

Next, as illustrated in b in the drawing, the lead frames 230 and 240 are pressed against and bonded to the upper portion of the lower resin frame 251 by the mold 300.

Then, as illustrated in a of Fig 18, an adhesive is applied by the dispenser 301 to an upper portion of the lead frames 230 and 240 bonded to the lower resin frame 251. b in the drawing is a plan view depicting a location where the adhesive is applied in a in the drawing. The adhesive is applied to the portion surrounded by the dotted lines in b in the drawing.

Then, as illustrated in Fig. 19, an upper resin frame 252 is pressed against and bonded to the upper portion of the lead frames 230 and 240 by a mold 302. This upper resin frame 252 corresponds to a portion on the upper side of the resin frame 250.

Then, as illustrated in a of Fig. 20, upper and lower sides of the resin frame 250 are fixed by a jig 303 and a mold 304, and unnecessary portions of the lead frames 230 and 240 are cut and the outer leads are molded by the mold 302. b in the drawing depicts a cross-sectional view of the outer lead 235 after molding.

a of Fig. 21 is an example of a plan view of the arrayed portion of the inner leads before the unnecessary portions are cut off in a of Fig. 20. As illustrated in a in the drawing, a location where the support frame 237 and the inner lead 232-2 are connected to each other is punched out by the mold 302. In a in the drawing, locations surrounded by the fine dotted lines indicates locations to be punched. Next, as illustrated in b in the drawing, the support frame 237 is removed.

Then, as illustrated in a of Fig 22, an adhesive is applied by the dispenser 301 to an upper portion of the resin frame 250. Next, as illustrated in b in the drawing, the dustproof glass 260 is mounted, and the cavity is sealed.

Fig. 23 is a flowchart illustrating an example of a method for manufacturing the semiconductor package 200 according to the first embodiment of the present technology. The sensor chip 210 is mounted on the lead frame 230 on the upper side by die bonding and wire bonding (step S901). Further, the logic chip 220 is mounted on the lead frame 240 on the lower side by die bonding and wire bonding (step S902).

Subsequently, the lead frames 230 and 240 are superimposed so that back surfaces thereof face each other (step S903), and the inner leads 232-2 and 242-2 commonly used in the upper and lower chips are connected by fitting or the like (step S904).

Subsequently, the lead frames 230 and 240 are bonded to the lower resin frame 251 (step S905), and the upper resin frame 252 is bonded thereto (step S906).

Subsequently, the unnecessary portions are cut off and the outer leads are molded (step S907). Next, the cavity is sealed by bonding the dustproof glass 260 (step S908), and the manufacturing process of the semiconductor package 200 is completed.

Thus, according to the first embodiment of the present technology, the island 231 of the lead frame 230 and the island 241 of the lead frame 240 are disposed with a predetermined spacing therebetween, and thus heat generated in the logic chip 220 is less likely to be conducted to the sensor chip 210. This makes it possible to suppress the performance deterioration of the semiconductor device 100.

### 2. Second Embodiment

In the first embodiment described above, the islands 231 and 241 are disposed in the cavity. In this configuration, however, warping may occur in the logic chip 220 on the lower side, which has a particularly large heat generation amount. The semiconductor package 200 according to a second embodiment differs from that of the first embodiment in that the island 241 is embedded in a mold resin.

Fig. 24 is a cross-sectional view depicting a configuration example of the semiconductor package 200 according to the second embodiment of the present technology. The semiconductor package 200 according to this second embodiment differs from that of the first embodiment in that the island 241 on the lower side is embedded in a mold resin 291.

Fig. 24 is a cross-sectional view depicting a configuration example of the semiconductor package 200 according to the second embodiment of the present technology. The semiconductor package 200 according to this second embodiment differs from that of the first embodiment in that the island 241 and the logic chip 220 on the lower side as well as a portion of the inner leads on the lower side are embedded in a mold resin 291. However, the island 231 is not embedded in the mold resin 291 so that heat is not conducted to the island 231 on the upper side.

By embedding the island 241 on the lower side in the mold resin 291, it is possible to suppress the warping of the logic chip 220 on the lower side as compared with a case in which embedding is not performed.

As described above, according to the second embodiment of the present technology, the island 241 on the lower side is embedded in the mold resin 291, making it possible to suppress the warping of the logic chip 220 compared with a case in the first embodiment.

### 3. Third Embodiment

In the first embodiment described above, the island 231 and the island 241 are disposed with a predetermined spacing therebetween. With this configuration, however, a heat dissipation amount to the outside may be insufficient. The semiconductor package 200 according to this third embodiment differs from that of the first embodiment in that a heat sink is connected.

Fig. 25 is a cross-sectional view depicting a configuration example of the semiconductor device 100 according to the third embodiment of the present technology. The semiconductor device 100 according to this third embodiment differs from that of the first embodiment in that a heat sink 120 is added.

Each of the frames of the lead frames 230 and 240 is extended so that a portion thereof protrudes outside the semiconductor package 200. The heat sink 120 is connected to the extended portion. With the extended portion connecting the heat sink 120, it is possible to increase the heat dissipation amount.

Fig. 26 is an example of a plan view of the collective frame 249 on the lower side according to the third embodiment of the present technology. In this third embodiment, the plurality of (four or the like) positioning holes 246 are formed in each of the plurality of lead frames 240, such as the lead frames 240-1 and 240-2. These positioning holes 246 are used for positioning as well as for connection with the heat sink 120. In the collective frame 239 (not illustrated) on the upper side as well, the plurality of positioning holes 236 are provided for each lead frame 230, and are used for positioning as well as for connection with the heat sink 120. The dotted lines in the drawing indicate the locations where the plurality of lead frames 240 are separated.

Note that, as illustrated in Fig. 27, the second embodiment can be applied to the third embodiment.

Thus, according to the third embodiment of the present technology, the heat sink 120 is connected to each of the frames of the lead frames 230 and 240, making it possible to increase the heat dissipation amount.

### Modifications

In the third embodiment described above, the heat sink 120 is connected. However, the heat dissipation amount of the logic chip 220 on the lower side, which has a particularly large heat generation amount, may be insufficient. The semiconductor device 100 according to this modification of the third embodiment differs from that of the third embodiment in that heat of the logic chip 220 is dissipated by a heat-conductive resin 292.

Fig. 28 is a cross-sectional view depicting a configuration example of the semiconductor device 100 according to the modification of the third embodiment of the present technology. The semiconductor device 100 according to this modification of the third embodiment differs from that of the third embodiment in that the heat-conductive resin 292 is added.

The heat-conductive resin 292 is disposed between the logic chip 220 on the lower side and the resin frame 250. The heat generated in the logic chip 220 is dissipated to the resin frame 250 by this heat-conductive resin 292.

Note that, as illustrated in Fig. 29, the heat-conductive resin 292 according to the modification of the third embodiment can also be added to the first embodiment without the heat sink 120.

Thus, according to the modification of the third embodiment of the present technology, the heat generated in the logic chip 220 is dissipated by the heat-conductive resin 292, making it possible to improve a heat dissipation performance.

### 4. Application Example of Mobile Body

The technology according to the present disclosure (present technology) can be applied to various products. For example, the technology according to the present disclosure may be realized as a device mounted on any type of mobile body such as an automobile, an electric vehicle, a hybrid electric vehicle, a motorcycle, a bicycle, a personal mobility, an airplane, a drone, a ship, and a robot.

Fig. 30 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in Fig. 30, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of Fig. 30, an audio speaker 12061, a display section 12062, and an instrument panel 12063 are illustrated as the output device. The display section 12062 may, for example, include at least one of an on-board display and a head-up display.

Fig. 31 is a diagram depicting an example of the installation position of the imaging section 12031.

In Fig. 31, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, Fig. 31 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour) . Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure can be applied has been described above. The technology according to the present disclosure can be applied to, for example, the imaging section 12031 among the configurations described above. Specifically, the semiconductor device 100 in Fig. 1 can be applied to the imaging section 12031. By applying the technology according to the present disclosure to the imaging section 12031, it is possible to suppress performance deterioration of the device caused by heat.

Note that the above-described embodiments illustrate examples for embodying the present technology, and the matters in the embodiments have corresponding relations with the matters specifying the invention in the scope of the claims. Similarly, the matters specifying the invention in the scope of the claims have corresponding relations with the matters in the embodiments of the present technology to which the same names are given. However, the present technology is not limited to the embodiments, and can be embodied by applying various modifications to the embodiments without departing from the gist thereof.

Note that the effects described in the present specification are merely examples and are not limited, and other effects may be provided.

Note that the present technology can also adopt configurations such as the following.
(1) A semiconductor package including
   a first semiconductor chip;
   a first lead frame including a first island on which the first semiconductor chip is mounted;
   a second semiconductor chip; and
   a second lead frame including a second island on which the second semiconductor chip is mounted, the second island being disposed at a predetermined spacing from the first island.
(2) The semiconductor package according to (1),
   wherein the first semiconductor chip is mounted on a front surface of the first island,
   the second semiconductor chip is mounted on a front surface of the second island, and
   a back surface of the first island relative to the front surface and a back surface of the second island relative to the front surface are disposed with the predetermined spacing between the back surfaces.
(3) The semiconductor package according to (1),
   wherein the first lead frame includes a plurality of first inner leads and the first island,
   the second lead frame includes a plurality of second inner leads and the second island, and
   a specific first inner lead of the plurality of first inner leads and a specific second inner lead of the plurality of second inner leads are connected.
(4) The semiconductor package according to (3),
   wherein the specific first inner lead and the specific second inner lead are connected to a power supply potential or a ground potential.
(5) The semiconductor package according to (3),
   wherein the specific first inner lead and the specific second inner lead transmit a signal from one of the first semiconductor chip and the second semiconductor chip to the other.
(6) The semiconductor package according to any one of (1) to (5), further including
   a mold resin,
   wherein one of the first island and the second island is embedded in the mold resin.
(7) The semiconductor package according to any one of (1) to (6), further including:
   a frame-like member including a cavity; and
   a heat-conductive resin that dissipates heat, generated in one of the first semiconductor chip and the second semiconductor chip, to the frame-like member,
   wherein the first island and the second island are disposed in the cavity.
(8) The semiconductor package according to any one of (1) to (7),
   wherein one of the first semiconductor chip and the second semiconductor chip is a sensor chip configured to generate image data by photoelectric conversion, and
   the other of the first semiconductor chip and the second semiconductor chip is a logic chip configured to process the image data.
(9) A semiconductor device including
   a semiconductor package including a first semiconductor chip, a first lead frame including a first island on which the first semiconductor chip is mounted, a second semiconductor chip, and a second lead frame including a second island on which the second semiconductor chip is mounted, the second island being disposed at a predetermined spacing from the first island; and
   a mounting substrate on which the semiconductor package is mounted.
(10) The semiconductor device according to (9), further including
   a heat sink connected to the first lead frame and the second lead frame.
(11) A method for manufacturing a semiconductor package, the method including
   mounting a first semiconductor chip on a first island of a first lead frame;
   mounting a second semiconductor chip on a second island of a second lead frame; and
   disposing the first lead frame and the second lead frame such that a predetermined spacing is formed between the first island and the second island.

### Reference Signs List

100 Semiconductor device
110 Mounting substrate
120 Heat sink
200 Semiconductor package
210 Sensor chip
211 Solid-state imaging element
212 Pixel array section
220 Logic chip
221 LSI
230, 230-1, 230-2, 240, 240-1, 240-2 Lead frame
231, 241 Island
232, 232-1, 232-2, 233, 242, 242-1, 242-2, 243 Inner lead
234, 244 Frame
235, 245 Outer lead
236, 246 Positioning hole
237, 247 Support frame
238 Protrusion
248 Recess
239, 249 Collective frame
250 Resin frame
251 Lower resin frame
252 Upper resin frame
260 Dustproof glass
281, 282 Die bonding resin
283, 283-1, 283-2, 284, 284-1, 284-2 Wire
291 Mold resin
292 Heat-conductive resin
300, 302, 304 Mold
301 Dispenser
303 Jig
12031 Imaging section

## Claims

1. A semiconductor package comprising:
a first semiconductor chip;
a first lead frame including a first island on which the first semiconductor chip is mounted;
a second semiconductor chip; and
a second lead frame including a second island on which the second semiconductor chip is mounted, the second island being disposed at a predetermined spacing from the first island.

2. The semiconductor package according to claim 1,
wherein the first semiconductor chip is mounted on a front surface of the first island,
the second semiconductor chip is mounted on a front surface of the second island, and
a back surface of the first island relative to the front surface and a back surface of the second island relative to the front surface are disposed with the predetermined spacing between the back surfaces.

3. The semiconductor package according to claim 1,
wherein the first lead frame includes a plurality of first inner leads and the first island,
the second lead frame includes a plurality of second inner leads and the second island, and
a specific first inner lead of the plurality of first inner leads and a specific second inner lead of the plurality of second inner leads are connected.

4. The semiconductor package according to claim 3,
wherein the specific first inner lead and the specific second inner lead are connected to a power supply potential or a ground potential.

5. The semiconductor package according to claim 3,
wherein the specific first inner lead and the specific second inner lead transmit a signal from one of the first semiconductor chip and the second semiconductor chip to the other.

6. The semiconductor package according to claim 1, further comprising:
a mold resin,
wherein one of the first island and the second island is embedded in the mold resin.

7. The semiconductor package according to claim 1, further comprising:
a frame-like member including a cavity; and
a heat-conductive resin that dissipates heat, generated in one of the first semiconductor chip and the second semiconductor chip, to the frame-like member,
wherein the first island and the second island are disposed in the cavity.

8. The semiconductor package according to claim 1,
wherein one of the first semiconductor chip and the second semiconductor chip is a sensor chip configured to generate image data by photoelectric conversion, and
the other of the first semiconductor chip and the second semiconductor chip is a logic chip configured to process the image data.

9. A semiconductor device comprising:
a semiconductor package including a first semiconductor chip, a first lead frame including a first island on which the first semiconductor chip is mounted, a second semiconductor chip, and a second lead frame including a second island on which the second semiconductor chip is mounted, the second island being disposed at a predetermined spacing from the first island; and
a mounting substrate on which the semiconductor package is mounted.

10. The semiconductor device according to claim 9, further comprising:
a heat sink connected to the first lead frame and the second lead frame.

11. A method for manufacturing a semiconductor package, the method comprising:
mounting a first semiconductor chip on a first island of a first lead frame;
mounting a second semiconductor chip on a second island of a second lead frame; and
disposing the first lead frame and the second lead frame such that a predetermined spacing is formed between the first island and the second island.
